# EUROPEAN PATENT APPLICATION

(11) **EP 4 700 935 A1**
(43) Date of publication of application: **25.02.2026**
(21) Application number: 24873868.4
(22) Date of filing: 09.08.2024
(51) Int. Cl.: H01M 50/20, H01M 50/503

(54) **SOLAR CELL, CELL STRING AND PHOTOVOLTAIC MODULE**

(30) Priority: 03.07.2024 CN 202421570954 U
(71) Applicant: Huansheng New Energy (Jiangsu) Co., Ltd., Yixing Wuxi, Jiangsu 214203 (CN)
(72) Inventor: MU, Chengwei, Wuxi, Jiangsu 214203 (CN); YANG, Qing, Wuxi, Jiangsu 214203 (CN); CHEN, Liangshui, Wuxi, Jiangsu 214203 (CN); WANG, Peng, Wuxi, Jiangsu 214203 (CN)
(74) Representative: Cristinelli, Luca
(86) International application number: PCT/CN2024/110916
(87) International publication number: WO 2026/007195

(57) **Abstract**

The present disclosure relates to a solar cell, a solar cell string, and a photovoltaic module, belonging to the technical field of solar cells. The solar cell includes: a solar cell substrate and a metal foil, wherein a rear surface of the solar cell substrate is provided with a rear-surface grid line, and the metal foil is connected to the rear-surface grid line. The backlight side of the solar cell substrate is provided with a layer of connecting grid lines of the metal foil, which can realize a lower line loss when the aluminum back surface field is thinner or even without the aluminum back surface field, or the dosage of the silver paste is fewer, so as to realize the less cutting in the preparation process, which is beneficial to reduce the loss of the solar cell, and does not cause the warping or cost increase at the same time.

## Description

### CROSS-REFERENCE TO RELATED APPLICATION

The present disclosure claims priority to Chinese Patent Application No. 2024215709541, entitled "SOLAR CELL, SOLAR CELL STRING, AND PHOTOVOLTAIC MODULE" filed on July 3, 2024, with the Chinese Patent Office, the entire contents of which are incorporated herein by reference.

### TECHNICAL FIELD

The present disclosure relates to the technical field of solar cell, and specifically to a solar cell, a solar cell string, and a photovoltaic module.

### BACKGROUND ART

At present, the line loss of a solar cell of a shingled solar cell is higher, requiring the solar cell to be cut into a smaller size to control the line loss. However, multiple cuts will cause damage to the solar cell, which affects the photoelectric conversion efficiency. In order to solve this problem, increasing the aluminum backfield wet weight (PERC cells) or increasing the amount of silver paste (TOPCon cells) is commonly adopted, but new problems are brought about. For example, the increase in the aluminum backfield wet weight will lead to an increase in the probability of the solar cell warping, which will lead to a decrease in the yield rate of the solar cell or a reduction in the suitability with the production device; or the increase in the dosage of the silver paste will lead to an increase in the cost of the solar cell.

### SUMMARY

The objective of the present disclosure is to provide a solar cell, a solar cell string, and a photovoltaic module, which can realize the low warping and low cost of the solar cell while reducing the line loss and cutting less.

In a first aspect, the embodiments of the present disclosure provide a solar cell, wherein the solar cell includes:
a solar cell substrate, wherein a rear surface of the solar cell substrate is provided with a rear-surface grid line; and
a metal foil, wherein the metal foil is connected to the rear-surface grid line.

In the above embodiment, the backlight side of the solar cell substrate is provided with a layer of connecting grid lines of the metal foil, which can realize a lower line loss when the aluminum back surface field is thinner or even without the aluminum back surface field, or the dosage of the silver paste is fewer, so as to realize the less cutting in the preparation process. This is beneficial to reduce the loss of the solar cell and does not cause the warping or cost increase at the same time.

As an optional embodiment, a thickness of the metal foil is 10 µm~30 µm.

In the above embodiment, the thicker the thickness of the metal foil is, the more beneficial it is for reducing the line loss of the solar cell; the thinner the thickness of the metal foil, the more advantageous it is for controlling the cost of the solar cell. By controlling the thickness of the metal foil to be 10 µm~30 µm, both the line loss and manufacturing cost of the solar cell can be balanced.

As an optional embodiment, an area of the metal foil is not larger than an area of the solar cell substrate, and a minimum distance between an edge of the metal foil and an edge of the solar cell substrate is 0~10 mm.

In the above embodiment, the larger the area of the metal foil is, the more beneficial it is for reducing the line loss of the solar cell, and the smaller the area of the metal foil is, the more advantageous it is for controlling the cost of the solar cell. By controlling the minimum distance between the edge of the metal foil and the edge of the body of the solar cell substrate to be 0~10 mm, it takes into account the line loss and the manufacturing cost of the solar cell.

As an optional embodiment, a length of the solar cell substrate is 182mm~210mm; and/or
a width of the solar cell substrate is 30mm~105mm.

In the above embodiment, since the metal foil is provided, the size of a solar cell can be larger under the same line loss, which reduces the amount of cuts, thereby reducing the damage to the solar cell caused by slicing. By controlling the length of the solar cell substrate to be 182mm~210mm and the width to be 30mm~105mm, it is beneficial for balancing the line loss and photoelectric conversion efficiency of the solar cell.

As an optional embodiment, the rear-surface grid line includes a busbar and a finger, wherein a thickness of the busbar is 3 µm~5 µm; a width of the busbar is 20 µm~40 µm; a spacing of the busbar is 5 mm~15 mm; a thickness of the finger is 5 µm~10 µm; a width of the finger is 10 µm~30 µm; and a spacing of the finger is 1 mm~2 mm.

In the above embodiment, since the metal foil is provided, the material used for the grid lines can be reduced under the same line loss. Accordingly, the width and thickness of the grid lines of the solar cell can be reduced, and the spacing can be enlarged. By controlling the thickness of the busbar to be 3µm~5µm, the width to be 20µm~40µm, and the spacing to be 5mm~15mm, and by controlling the thickness of the finger to be 5µm~10µm, the width to be 10µm~30µm, and the spacing to be 1mm~2mm, it can take into account the line loss and the manufacturing cost of the solar cell.

As an optional embodiment, the rear-surface grid line includes a busbar, wherein a thickness of the busbar is 3 µm~5 µm; a width of the busbar is 20 µm~40 µm; and a spacing of the busbar is 1 mm~2 mm.

In the above embodiment, since the metal foil is provided, the material used for the grid lines can be reduced under the same line loss. Accordingly, the width and thickness of the grid lines of the solar cell can be reduced, the spacing can be enlarged, and the finger can be not provided. By controlling the thickness of the busbar to be 3µm~5µm, the width to be 20µm~40µm, and the spacing to be 1mm~2mm, it can take into account the line loss and the manufacturing cost of the solar cell.

As an optional embodiment, the metal foil and the rear-surface grid line are connected by a conductive connection layer.

As an optional embodiment, the conductive connection layer is made of a material including dispensed silver paste, a solder paste printing, or an electrically conductive adhesive.

As an optional embodiment, the metal foil and the solar cell substrate are connected at a position including a solder pad of the solar cell substrate.

In the above implementation, the metal foil and the solar cell substrate are connected by the solder pad, which is beneficial to the connection reliability and conductivity of the two.

In a second aspect, the embodiments of the present disclosure provide a solar cell string, wherein the solar cell string includes:
at least two solar cells provided in the first aspect;
a solder ribbon, wherein the solder ribbon is connected to a main-surface grid line on a front surface of the solar cell; and
a connecting part, wherein one end of the connecting part is connected to the metal foil of one solar cell of the two adjacent solar cells, and the other end of the connecting part is connected to the solder ribbon arranged on the front surface of the other solar cell of the two adjacent solar cells.

In the above implementation, a layer of metal foil is arranged on the backlight side of the solar cell to replace the connecting grid line of the solder ribbon, which can realize the lower line loss when the aluminum back surface field is thinner or even without the aluminum back surface field, or the dosage of the silver paste is fewer, so as to realize the less cutting of the preparation process, which is beneficial to reduce the loss of the solar cell, and does not cause the warping or cost increase at the same time.

As an optional embodiment, the connecting part is a connecting solder ribbon, wherein the connecting solder ribbon and the solder ribbon are integrally molded.

As an optional embodiment, the connecting solder ribbon has a flat part; the flat part is connected to the metal foil; and a thickness of the flat part is not larger than 100 µm.

In the above embodiment, controlling the thickness of the flat part is beneficial to control a thickness of the back-side adhesive layer, and also beneficial for the welding with the solar cell, thereby reducing potential cracks of the solar cell.

As an optional embodiment, the connecting part is a connecting metal foil, wherein the connecting metal foil and the metal foil are integrally molded.

As an optional embodiment, a width of an overlapping region of the connecting metal foil and the front surface of the solar cell substrate is no more than 1mm.

In the above embodiment, by controlling the width of the overlapping region, it can reduce the influence on the light-receiving region of the front surface, which is beneficial to improve the photoelectric conversion efficiency.

In a third aspect, the embodiments of the present disclosure provide a photovoltaic module, wherein the photovoltaic module includes the solar cell string provided by the second aspect.

### BRIEF DESCRIPTION OF DRAWINGS

In order to more clearly illustrate the technical solutions of the examples of the present disclosure, the drawings to be used in the examples will be briefly introduced below. It should be understood that the following drawings only show certain examples of the present disclosure, and therefore should not be regarded as a limitation of the scope. Other relevant drawings can be obtained from these drawings by a person of ordinary skill in the art without inventive efforts.
FIG. 1 shows a schematic structure diagram of a backlight side of a solar cell provided by the embodiments of the present disclosure;
FIG. 2 shows a schematic structure diagram of a rear-surface grid line provided by the embodiments of the present disclosure;
FIG. 3 shows a partially enlarged schematic diagram at A in FIG. 2;
FIG. 4 shows another schematic structure diagram of a rear-surface grid line provided by the embodiments of the present disclosure;
FIG. 5 shows a schematic structure diagram of a shingled photovoltaic module provided by the embodiments of the present disclosure; and
FIG. 6 shows another schematic structure diagram of a shingled photovoltaic module provided by the embodiments of the present disclosure.

Reference numbers: 1000-solar cell string; 1100-solar cell; 1110-solar cell substrate; 1111-main-surface grid line; 1112-rear-surface grid line; 1112a-busbar; 1112b-finger; 1113-solder pad; 1120-metal foil; 1200-solder ribbon; 1300-connecting part; and 1310-flat part.

### DETAILED DESCRIPTION OF EMBODIMENTS

In order to make the objective, technical solutions, and advantages of the embodiments of the present disclosure clearer, the technical solutions in the examples of the present disclosure will be described clearly and completely below in conjunction with drawings in the embodiments of the present disclosure. Obviously, the embodiments described above are partial embodiments of the present disclosure, and are not all embodiments. The components of embodiments of the present disclosure generally described and shown in the drawings herein can be arranged and designed in various configurations.

In the description of the present disclosure, it should be noted that the orientation or position relationship indicated by the terms "inside", "outside", etc., are the orientations or position relationships based on the drawings, or the orientations or position relationships of the product of the present disclosure customarily placed in use, which are only to facilitate the description of the present disclosure and simplify the description, and are not to indicate or imply that the device or element referred to must have a particular orientation, or be constructed and operated with a particular orientation, and therefore cannot to be understood as limitations of the present disclosure. Additionally, the terms "first", and "second", etc., are used only to differentiate the description, and are not to be understood as indicating or implying relative importance.

In the description of the present disclosure, it should further be noted that unless other express specifications and limitations, the terms "arrange" and "connect" are to be understood in a broad sense, e.g. it can be a fixed connection, a detachable connection, or an integral connection; and it can be a direct connection, an indirect connection through an intermediate medium, or a communication inside two components. For a person of ordinary skill in the art, the specific meaning of the above terms in the present disclosure can be understood according to specific situations.

At present, the line loss of a solar cell 1100 of a shingled solar cell is higher, and it needs to be cut into a smaller size to control the line loss. However, multiple cuts will cause damage to the solar cell 1100, which affects the photoelectric conversion efficiency. In order to solve this problem, it is usually to increase the aluminum back surface field wet weight (for the PERC solar cell) or to increase the dosage of the silver paste (for the TOPCon solar cell), but new problems are brought about. For example, the increase in the aluminum back surface field wet weight will lead to an increase in the probability of warping of the solar cell 1100, which will lead to a decrease in the yield rate of the solar cell 1100 or a reduction in the suitability with the production device; or the increase in the dosage of the silver paste will lead to an increase in the cost of the solar cell 1100.

In view of this, the present disclosure intends to provide a solar cell 1100, wherein a metal foil 1120 is arranged on a rear surface of a solar cell substrate 1110, which can realize the low warping and low cost of the solar cell 1100 while reducing the line loss and cutting less.

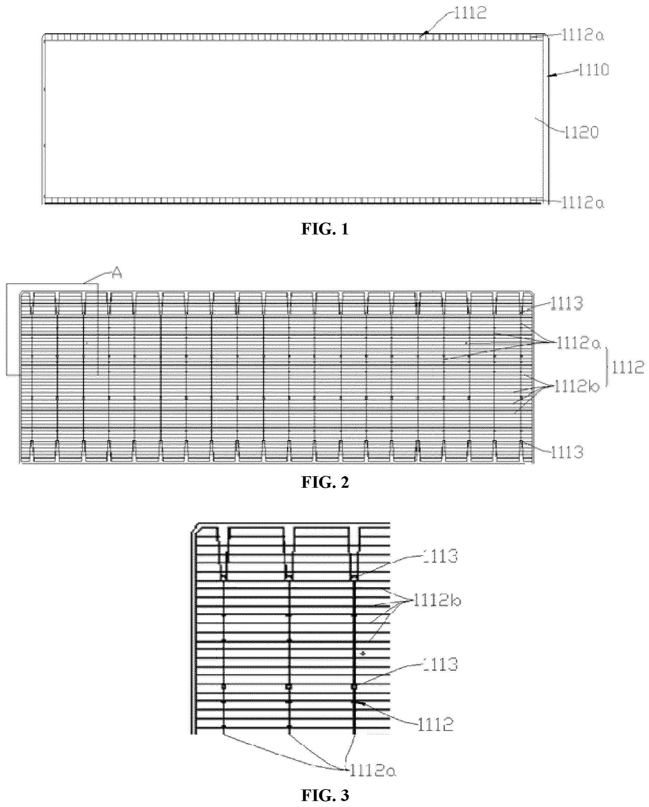

FIG. 1 shows a schematic structure diagram of a backlight side of a solar cell 1100 provided by the embodiments of the present disclosure. As shown in FIG. 1, the embodiment of the present disclosure provides a solar cell 1100, and the solar cell 1100 includes: a solar cell substrate 1110 and a metal foil 1120, wherein a rear surface of the solar cell substrate 1110 is provided with a rear-surface grid line 1112, and the metal foil 1120 is connected to the rear-surface grid line 1112.

In the solar cell 1100, the backlight side of the solar cell substrate 1110 is provided with a layer of connecting grid lines of the metal foil 1120, which can realize the lower line loss when the aluminum back surface field is thinner or even without the aluminum back surface field, or the dosage of the silver paste is fewer, so as to realize the less cutting of the preparation process, which is beneficial to reduce the loss of the solar cell 1100, and does not cause the warping or cost increase at the same time.

It should be noted that the connection between the metal foil 1120 and the solar cell substrate 1110 can be realized by dispensed silver paste, a solder paste printing, or an electrically conductive adhesive, etc., of which the curing can be realized by a curing oven (with a long-distance heating channel having functions as platform adsorption, hot air circulation, warming, holding, and cooling). The conductive connection layer is formed after the curing. The conductive connection layer is arranged on the solar cell substrate 1110 by distributed dotting or other methods. Exemplarily, the solder paste can be a conventional welding weld paste, wherein a metal content is 85%~90%; an alloy composition is Sn63Pb37 or Sn60Pb40, and a flux paste content is 10%~15%. The electrically conductive adhesive can be an adhesive with bonding materials, such as the UV adhesive, heat-curing adhesive, or electrically conductive adhesive. The solder paste and the electrically conductive adhesive mainly play a bonding function, and the silver paste points of the solar cell 1100 are bonded to copper foil/aluminum foil, with an additional conductive function. It can be understood that in other embodiments, the person skilled in the art can also use other materials to form the conductive connection layer.

In some embodiments, the metal foil 1120 and the solar cell substrate 1110 are connected at a position including a solder pad 1113 of the solar cell substrate 1110. It can be understood that the conductive connection layer can be arranged at the position of the solder pad 1113 on the solar cell substrate 1110, so that the metal foil 1120 and the solar cell substrate 1110 are connected. Connecting the metal foil 1120 and the solar cell substrate 1110 by the solder pad 1113 is beneficial to the connection reliability and conductivity of the two. Of course, it can be understood by those skilled in the art that in addition to realizing the connection between the metal foil 1120 and the solar cell substrate 1110 at the solder pad 1113, the connection can be made at any other position of the rear-surface grid line 1112.

Generally, cover glasses are further arranged on two sides of the solar cell 1100, and an adhesive film is filled between the cover glass and the solar cell substrate 1110, so as to protect the solar cell substrate 1110, wherein the solder ribbon 1200 and the metal foil 1120 are embedded in the adhesive film.

Since the solder ribbon 1200 on the backlight side is replaced by the metal foil 1120, and the thickness of the metal foil 1120 is much smaller than the thickness of the solder ribbon 1200, the adhesive film can be thinned, which is further beneficial to the control of the cost of the solar cell 1100.

In some embodiments, the metal foil 1120 can be selected from aluminum foil or copper foil.

The thicker the thickness of the metal foil 1120 is, the more conducive to the reduction of the line loss of the solar cell 1100 is, and the thinner the thickness of the metal foil 1120, the more conducive to the control of the cost of the solar cell 1100. In some embodiments, the thickness of the metal foil 1120 is 10 µm~30 µm. By controlling the thickness of the metal foil 1120 to be 10 µm~30 µm, it takes into account the line loss and the manufacturing cost of the solar cell 1100.

Exemplarily, the thickness of the metal foil 1120 can be 10 µm, 12 µm, 14 µm, 16 µm, 18 µm, 20 µm, 22 µm, 24 µm, 26 µm, 28 µm, or 30 µm, etc., and it can be any value in a range of 10 µm~30 µm.

The larger the area of the metal foil 1120 is, the more conducive to the reduction of the line loss of the solar cell 1100, and the smaller the area of the metal foil 1120, the more conducive to the control of the cost of the solar cell 1100 is. In some embodiments, an area of the metal foil 1120 is not larger than an area of the solar cell substrate 1110, and a minimum distance between an edge of the metal foil 1120 and an edge of the solar cell substrate 1110 is 0~10 mm. The minimum distance between the edge of the metal foil 1120 and the edge of the solar cell substrate 1110 refers to a distance between the edge of the metal foil 1120 and the edge of the corresponding solar cell. By controlling the minimum distance between the edge of the metal foil 1120 and the edge of the solar cell substrate 1110 to be 0~10 mm, it takes into account the line loss and the manufacturing cost of the solar cell 1100.

Exemplarily, the minimum distance between the edge of the metal foil 1120 and the edge of the solar cell substrate 1110 can be 0 mm, 0.5 mm, 1 mm, 1.5 mm, 2 mm, 2.5 mm, 3 mm, 3.5 mm, 4 mm, 4.5 mm, 5 mm, 5.5 mm, 6 mm, 6.5 mm, 7 mm, 7.5 mm, 8 mm, 8.5 mm, 9 mm, 9.5 mm, 10 mm, etc., and it can be any value in a range of 0~10 mm.

Since the metal foil 1120 is provided, the size of the single solar cell can be larger under the same line loss, reducing the number of slices (to less than 3), and thus the loss of slicing to the solar cell 1100 is reduced. Generally, the sizes of uncut solar cells 1100 can be 210*210, 182*182, 210* 182, etc. Therefore, in some embodiments, the length of the solar cell substrate 1110 is 182mm~210mm, and the width of the solar cell substrate 1110 is 30mm~105mm. By controlling the length of the solar cell substrate 1100 to be 182mm~210mm and the width to be 30mm~105mm, it is beneficial to take into account the line loss and the photoelectric conversion efficiency of the solar cell 1100.

Since the metal foil 1120 is provided, the material used for the grid lines can be reduced under the same line loss. Accordingly, the width and thickness of the grid lines of the solar cell 1100 can be reduced, and the spacing can be enlarged.

FIG. 2 and FIG. 3 are schematic structure diagrams of the rear-surface grid line 1112 provided by the embodiments of the present disclosure. As shown in FIG. 2 and FIG. 3, in some embodiments, the rear-surface grid line 1112 can be provided with a busbar 1112a and a finger 1112b. At this time, there are two paths for the current transmission of the solar cell 1100, wherein one path is to gather the current to the busbar 1112a by the finger 1112b, which is then transmitted by the busbar 1112a and the metal foil 1120; and the other path is transmitted through the finger 1112b directly contacting the metal foil 1120. Further, a thickness of the busbar 1112a is 3 µm~5 µm; a width of the busbar 1112a is 20 µm~40 µm; a spacing of the busbar 1112a is 5 mm~15 mm; a thickness of the finger 1112b is 5 µm~10 µm; a width of the finger 1112b is 10 µm~30 µm; and a spacing of the finger 1112b is 1 mm~2 mm. By controlling the thickness of the busbar 1112a to be 3µm~5µm, the width to be 20µm~40µm, and the spacing to be 5mm~15mm, and by controlling the thickness of the finger 1112b to be 5µm~10µm, the width to be 10µm~30µm, and the spacing to be 1mm~2mm, it can take into account the line loss and the manufacturing cost of the solar cell 1100.

Exemplarily, the thickness of the busbar 1112a can be 3 µm, 3.2 µm, 3.4 µm, 3.6 µm, 3.8 µm, 4 µm, 4.2 µm, 4.4 µm, 4.6 µm, 4.8 µm, or 5 µm, etc., and it can be any value in a range of 3 µm~5 µm. The width of the busbar 1112a can be 20 µm, 21 µm, 22 µm, 23 µm, 24 µm, 25 µm, 26 µm, 27 µm, 28 µm, 29 µm, 30 µm, 31 µm, 32 µm, 33 µm, 34 µm, 35 µm, 36 µm, 37 µm, 38 µm, 39 µm, or 40 µm, etc., and it can be any value in a range of 20 µm~40 µm. The spacing of the busbars 1112a can be 5 mm, 6 mm, 7 mm, 8 mm, 9 mm, or 10 mm, etc., and it can also be any value in a range of 5 mm~15 mm. The thickness of the finger 1112b can be 5 µm, 5.2 µm, 5.4 µm, 5.6 µm, 5.8 µm, 6 µm, 6.2 µm, 6.4 µm, 6.6 µm, 6.8 µm, 7 µm, 7.2 µm, 7.4 µm, 7.6 µm, 7.8 µm, 8 µm, 8.2 µm, 8.4 µm, 8.6 µm, 8.8 µm, 9 µm, 9.2 µm, 9.4 µm, 9.6 µm, 9.8 µm, or 10 µm, etc., and it can also be any value in a range of 5 µm~10 µm. The width of the finger 1112b can be 10 µm, 11 µm, 12 µm, 13 µm, 14 µm, 15 µm, 16 µm, 17 µm, 18 µm, 19 µm, 20 µm, 21 µm, 22 µm, 23 µm, 24 µm, 25 µm, 26 µm, 27 µm, 28 µm, 29 µm, or 30 µm, etc., and it can be any value in a range of 10 µm~30 µm. The spacing of the finger 1112b can be 1 mm, 1.1 mm, 1.2 mm, 1.3 mm, 1.4 mm, 1.5 mm, 1.6 mm, 1.7 mm, 1.8 mm, 1.9 mm, or 2 mm, etc., and it can also be any value in a range of 1 mm~2 mm.

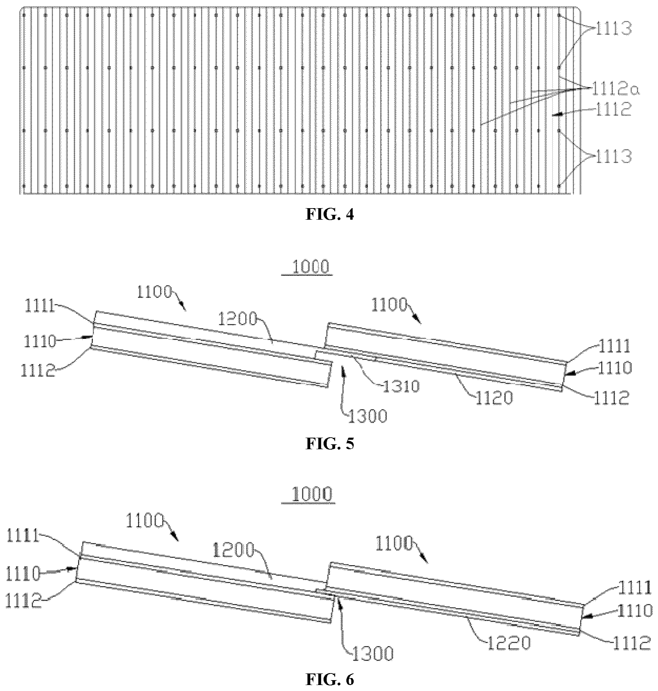

FIG. 4 shows a schematic structure diagram of the rear-surface grid line 1112 provided by the embodiments of the present disclosure. As shown in FIG. 4, in some embodiments, the rear-surface grid line 1112 can be arranged only as the busbar 1112a. At this moment, the current transmission path of the solar cell 1100 is transmitted by the busbar 1112a and the metal foil 1120. Further, the thickness of the busbar 1112a is 3 µm~5 µm; the width of the busbar 1112a is 20 µm~40 µm; and the spacing of the busbar 1112a is 1 µm ~2 µm. By controlling the thickness of the busbar 1112a to be 3 µm~5 µm, the width to be 20 µm~40 µm, and the spacing to be 1 µm ~2 µm, it can take into account the line loss and the manufacturing cost of the solar cell 1100.

Exemplarily, the thickness of the busbar 1112a can be 3 µm, 3.2 µm, 3.4 µm, 3.6 µm, 3.8 µm, 4 µm, 4.2 µm, 4.4 µm, 4.6 µm, 4.8 µm, or 5 µm, etc., and it can be any value in the range of 3 µm~5 µm. The width of the busbar 1112a can be 20 µm, 21 µm, 22 µm, 23 µm, 24 µm, 25 µm, 26 µm, 27 µm, 28 µm, 29 µm, 30 µm, 31 µm, 32 µm, 33 µm, 34 µm, 35 µm, 36 µm, 37 µm, 38 µm, 39 µm, or 40 µm, etc., and it can be any value in the range of 20 µm~40 µm. The spacing of the busbars 1112a can be 1 mm, 1.1 mm, 1.2 mm, 1.3 mm, 1.4 mm, 1.5 mm, 1.6 mm, 1.7 mm, 1.8 mm, 1.9 mm, or 2 mm, etc., and it can also be any value in the range of 1 mm~2 mm.

FIG. 5 and FIG. 6 are schematic structure diagrams of a solar cell string 1000 provided by an embodiment of the present disclosure. As shown in FIG. 5 and FIG. 6, based on the same aspect conception, the embodiment of the present application provides a solar cell string 1000, wherein the solar cell string 1000 includes a plurality of solar cells 1100, solder ribbons 1200, and connecting parts 1300 provided above; the solar cell substrate 1110 includes a silicon substrate, a main-surface grid line 1111 arranged on a front surface of the silicon substrate, and a rear-surface grid line 1112 arranged on a rear surface of the silicon substrate; the solder ribbon 1200 is connected to the main-surface grid line 1111; the metal foil 1120 is connected to the rear-surface grid line 1112; the plurality of solar cells 1100 are distributed in a shingled manner. Two adjacent solar cells 1100 are connected by the connecting part 1300, wherein one end of the connecting part 1300 is connected to the solder ribbon 1200 of one solar cell 1100, and the other end of the connecting part 1300 is connected to the metal foil 1120 of the other solar cell 1100.

The solar cell string 1000 is realized based on the above solar cell 1100, and the specific content of the solar cell 1100 can be referred to in the above embodiments. Since the solar cell string 1000 adopts some or all of the technical solutions of the above embodiments, it at least possesses beneficial effects brought about by the technical solutions of the above embodiments, which are not repeated herein.

The solar cell string 1000 replaces the solder ribbon 1200 by providing a layer of metal foil 1120 on the rear surface of the solar cell 1100 to connect the rear-surface grid line 1112, which can realize the lower line loss when the aluminum back surface field is thinner or even without the aluminum back surface field, or the dosage of the silver paste is fewer. This realizes the less cutting of the preparation process, which is beneficial to reduce the loss of the solar cell 1100, and does not cause the warping or cost increase at the same time.

Referring to FIG. 5, in some embodiments, the connecting part 1300 can be formed by the extension of the solder ribbon 1200, That is, the connecting part 1300 is a connecting solder ribbon, and the connecting solder ribbon and the solder ribbon 1200 are integrally molded.

Further, the connecting solder ribbon has a flat part 1310; the flat part 1310 is connected to the metal foil 1120; and a thickness of the flat part 1310 is not larger than 100 µm. That controlling the thickness of the flat part 1310 is beneficial to control a thickness of the back-side adhesive layer, and is also beneficial for welding with the solar cell 1100, thereby reducing potential cracks of the solar cell 1100. It can be understood that the smaller the thickness of the flat part 1310, the better. However, at present, due to the limitation of the preparation process, the limit thickness of the flat part 1310 pressed on the solder ribbon 1200 is about 20 µm, so that the thickness of the flat part 1310 in the range of 20 µm~100 µm is a preferable range that can be realized at present. When the preparation process is further optimized, the flat part 1310 can be thinner.

Exemplarily, the thickness of the flat part 1310 can be 10 µm, 15 µm, 20 µm, 25 µm, 30 µm, 35 µm, 40 µm, 45 µm, 50 µm, 55 µm, 60 µm, 65 µm, 70 µm, 75 µm, 80 µm, 85 µm, 90 µm, 95 µm, or 100 µm, etc., and it can be any value in a range of no more than 100 µm.

Referring to FIG. 6, in some embodiments, the connecting part 1300 can be formed by the extension of the metal foil 1120. That is, the connecting part 1300 is a connecting metal foil, and the connecting metal foil and the metal foil 1120 are integrally molded.

Further, a width of an overlapping region of the connecting metal foil and the front surface of the solar cell substrate 1110 is no more than 1mm. The width of the overlapping region is the length of each solar cell 1100 in the connection direction. By controlling the width of the overlapping region, it can reduce the influence on the light-receiving region of the front surface, which is beneficial to improve the photoelectric conversion efficiency.

Exemplarily, the width of the overlapping region of the connecting metal foil and the front surface of the solar cell substrate 1110 can be 0.1 mm, 0.2 mm, 0.3 mm, 0.4 mm, 0.5 mm, 0.6 mm, 0.7 mm, 0.8 mm, 0.9 mm, or 1 mm, etc., and it can also be any value in a range of no more than 1 mm.

Based on the same aspect conception, an embodiment of the present disclosure provides a photovoltaic module, wherein the photovoltaic module includes the solar cell string 1000 as provided above.

The photovoltaic module is realized based on the above solar cell string 1000, and the specific content of the solar cell string 1000 can be referred to in the above embodiments. Since the photovoltaic module adopts some or all of the technical solutions of the above embodiments, it has at least all beneficial effects brought about by the technical solutions of the above embodiments, which is not repeated herein.

It is noted that features in embodiments of the present disclosure can be combined with each other without conflict.

The foregoing is merely preferred embodiments of the present disclosure and is not intended to limit the present disclosure, and the present disclosure has various modification changes for those skilled in the art. Any modifications, equivalent substitutions, improvements, etc. made within the spirit and principles of the present disclosure shall be included in the scope of protection of the present disclosure.

## Claims

1. A solar cell, wherein the solar cell comprises:
a solar cell substrate, wherein a rear surface of the solar cell substrate is provided with a rear-surface grid line; and
a metal foil, wherein the metal foil is connected to the rear-surface grid line.

2. The solar cell according to claim 1, wherein a thickness of the metal foil is 10 µm~30 µm.

3. The solar cell according to claim 1, wherein an area of the metal foil is not larger than a rear-surface area of the solar cell substrate, and a minimum distance between an edge of the metal foil and an edge of the solar cell substrate is 0~10 mm.

4. The solar cell according to claim 1, wherein a length of the solar cell substrate is 182mm~210mm; and/or
a width of the solar cell substrate is 30mm~105mm.

5. The solar cell according to claim 1, wherein the rear-surface grid line comprises a busbar and a finger; a thickness of the busbar is 3 µm~5 µm; a width of the busbar is 20 µm~40 µm; a spacing of the busbar is 5 mm~15 mm; a thickness of the finger is 5 µm~10 µm; a width of the finger is 10 µm~30 µm; and a spacing of the finger is 1 mm~2 mm.

6. The solar cell according to claim 1, wherein the rear-surface grid line comprises a busbar; a thickness of the busbar is 3 µm~5 µm; a width of the busbar is 20 µm~40 µm; and a spacing of the busbar is 1 mm~2 mm.

7. The solar cell according to claim 1, wherein the metal foil and the rear-surface grid line are connected by a conductive connection layer; and/or
a material of the conductive connection layer is a dispensed silver paste, a solder paste printing, or an electrically conductive adhesive.

8. The solar cell according to claim 1, wherein the metal foil and the solar cell substrate are connected at a position comprising a solder pad of the solar cell substrate.

9. A solar cell string, wherein the solar cell string comprises:
at least two solar cells according to any one of claims 1 to 8;
a solder ribbon, wherein the solder ribbon is connected to a main-surface grid line on a front surface of the solar cell; and
a connecting part, wherein one end of the connecting part is connected to the metal foil of one solar cell of the two adjacent solar cells, and another end of the connecting part is connected to the solder ribbon arranged on the front surface of another solar cell of the two adjacent solar cells.

10. The solar cell string according to claim 9, wherein the connecting part is a connecting solder ribbon, and the connecting solder ribbon and the solder ribbon are integrally molded.

11. The solar cell string according to claim 10, wherein the connecting solder ribbon has a flat part; the flat part is connected to the metal foil; and a thickness of the flat part is not greater than 100 µm.

12. The solar cell string according to claim 9, wherein the connecting part is a connecting metal foil, and the connecting metal foil and the metal foil are integrally molded.

13. The solar cell string according to claim 12, wherein a width of an overlapping region of the connecting metal foil and a front surface of the solar cell substrate is no more than 1mm.

14. A photovoltaic module, wherein the photovoltaic module comprises the solar cell string according to any one of claims 9 to 13.
